# EUROPEAN PATENT SPECIFICATION

(11) **EP 2 790 482 B1**
(45) Date of publication and mention of the grant of the patent: **17.04.2019**
(21) Application number: 12855408.6
(22) Date of filing: 29.11.2012
(51) Int. Cl.: H05K 13/02, B65H 21/00

(54) **SPLICING DEVICE**
SPLEISSVORRICHTUNG
DISPOSITIF D'ÉPISSURAGE

(30) Priority: 08.12.2011 JP 2011268867
(43) Date of publication of application: 15.10.2014
(73) Proprietor: FUJI Corporation, Chiryu Aichi (JP)
(72) Inventor: CHI, Xiaodong, Chiryu Aichi (JP)
(74) Representative: Grünecker Patent- und Rechtsanwälte PartG mbB
(86) International application number: PCT/JP2012/080974
(87) International publication number: WO 2013/084796

(56) References cited:
- EP-A1- 0 613 339
- EP-A1- 0 613 339
- DE-U1- 29 905 736
- GB-A- 1 463 338
- JP-A- H06 100 217
- JP-A- 2002 207 286
- JP-U- S62 153 246
- US-A- 3 136 678
- US-A- 3 428 511
- US-A- 5 354 408

## Description

### Technical Field

The present invention relates to a splicing device used when adding a new tape to an old tape in a tape feeder which supplies electronic components to an electronic component mounting apparatus, for example.

### Background Art

A tape feeder is mounted on an electronic component mounting apparatus. A tape is loaded in the tape feeder. Multiple electronic components are accommodated in the tape with predetermined intervals in a longitudinal direction. As the electronic components are placed on a substrate from the tape, the number of electronic components of the tape gradually decreases. A new tape having the electronic components of the same component type is connected to the old tape in which the remaining amount of the electronic components reaches a predetermined amount or less. The connecting work is called splicing work.

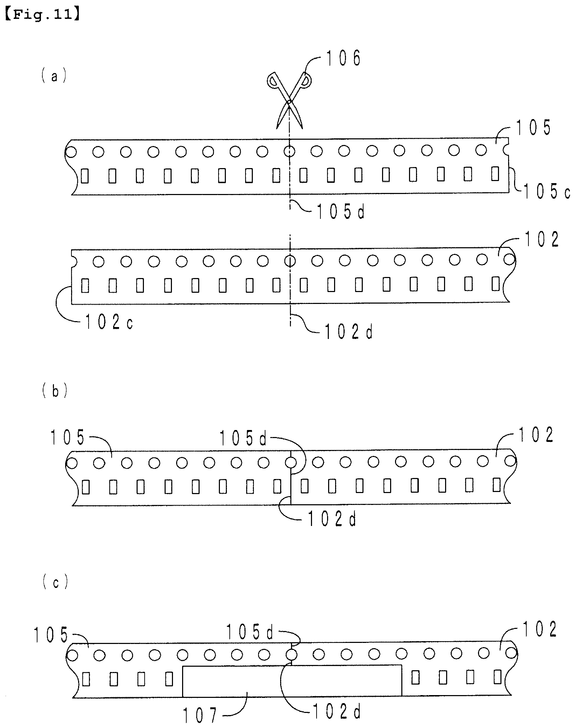

Fig. 11(a) illustrates a schematic diagram of a first stage in the splicing work of the tape. Fig. 11(b) illustrates a schematic diagram of a second stage in the splicing work of the tape. Fig. 11(c) illustrates a schematic diagram of a third stage in the splicing work of the tape.

In the splicing work, as illustrated in Fig. 11(a), an operator first cuts at the vicinity of a leading edge 105c of a new tape 105 at a predetermined cutting position 105d by using scissors 106. Similarly, the operator cuts off at the vicinity of a trailing edge 102c of a tape-in-use 102 at a predetermined cutting position 102d by using scissors 106.

Next, as illustrated in Fig. 11(b), the operator aligns the cutting position 105d of the new tape 105 with the cutting position 102d of the tape-in use 102. Then, as illustrated in Fig. 11(c), the operator connects the new tape 105 and the tape-in-use 102 by using a splice tape 107. In this manner, the splicing work is carried out.

### Citation List

### Patent Literature

PTL 1: JP-A-1-30939S Documents EP 0 613 339 and US 3 136 678 present devices for folding a splice tape over tapes to be connected and splicing these tapes with the splice tape.

### Summary of Invention

### Technical Problem

However, the splicing work is cumbersome since the splicing work is manually carried out by an operator. In addition, there is a possibility that the operator may touch an adhesive surface of the splice tape 107 during the work. Therefore, there is a possibility that adhesive strength of the splice tape 107 may be weakened by sweat or dirt adhering thereto. In addition, splicing accuracy eventually depends on the skill proficiency of the operator.

In this regard, PTL 1 discloses a splicing device which carries out the splicing work without depending on manual work by the operator. When the splicing work is carried out by the splicing device disclosed in PTL 1, a pair of new and old tapes are first set on a pair of tape holding bases. Next, the pair of tape holding bases are reversed. Subsequently, the splice tape adheres to an upward surface (front surface) of the pair of new and old tapes. Then, the pair of tape holding bases are reversed again. Then, the splice tape adheres to the downward surface (rear surface) of the pair of new and old tapes. In this manner, the splicing work is carried out. According to the splicing device disclosed in PTL 1, it is possible to easily carry out the splicing work. In addition, there is little possibility that the operator may touch the adhesive surface of the splice tape 107 during the work. In addition, the splicing accuracy is unlikely to depend on the skill proficiency of the operator.

However, according to the splicing device disclosed in PTL 1, it is necessary to rotate the pair of tape holding bases, that is, the pair of new and old tapes, multiple times for a stationary splice tape when the splicing work is carried out. Therefore, there is a possibility that the pair of new and old tapes may cause positional deviation from each other. That is, there is a possibility that the splicing accuracy may be degraded. In this case, there is a possibility that the new tape may be connected to the old tape by being bent similar to a polygonal line. In addition, there is a possibility that a pitch of a tape feeding hole may arrange same in a seam between the pair of new and old tapes.

A splicing device of the present invention is made in view of the above-described circumstances. The present invention aims to provide a splicing device where splicing accuracy is unlikely to be degraded.

### Solution to Problem

(1) In order to solve the above-described problem, a splicing device of the present invention includes a tape connecting unit that has a stationary pressing member and a movable pressing member which can switch between an open position opened to the stationary pressing member and a close position closed to the stationary pressing member. In the open position, a splice tape is arranged across the movable pressing member and the stationary pressing member. In the open position, a first connecting end portion of a first tape and a second connecting end portion of a second tape are arranged on a surface of a portion of the stationary pressing member side within the splice tape. By the open position being switched over to the close position, the movable pressing member is closed to the stationary pressing member, the movable pressing member is overlapped with the stationary pressing member in a front and rear direction, the splice tape is folded between the movable pressing member and the stationary pressing member, the first connecting end portion and the second connecting end portion are clamped by the splice tape from the front and rear direction, and the first connecting end portion and the second connecting end portion are connected to each other.
   In the open position, the splice tape is arranged across the movable pressing member and the stationary pressing member. Then, the first connecting end portion of the first tape and the second connecting end portion of the second tape are arranged on the surface of the portion of the stationary pressing member side within the splice tape. The surface of the splice tape is an adhesive surface. However, at this point of time, the rear surface of the first connecting end portion and the rear surface of the second connecting end portion may adhere to or may not adhere to the adhesive surface.
   When the open position is switched over to the close position, the movable pressing member is closed to the stationary pressing member. Therefore, the movable pressing member is overlapped with the stationary pressing member in the front and rear direction. At this time, the splice tape is folded between the movable pressing member and the stationary pressing member. In addition, the first connecting end portion and the second connecting end portion are clamped by the splice tape from the front and rear direction. By being clamped, the front surface of the first connecting end portion and the front surface of the second connecting end portion adhere to the rear surface of the splice tape. Then, the rear surface of the first connecting end portion and the rear surface of the second connecting end portion adhere to the front surface of the splice tape. Clamping force is applied to a stacked body of the splice tape, the first connecting end portion and the second connecting end portion from the front and rear direction. Accordingly, the first connecting end portion and the second connecting end portion firmly adhere to each other from the front and rear direction by the splice tape. In this manner, the first connecting end portion of the first tape and the second connecting end portion of the second tape are connected to each other by the splice tape.
   According to the splicing device of the present invention, it is possible to easily carry out the inherently cumbersome splicing work. In addition, only when the splice tape, the first tape and the second tape are set in the open position, there is a possibility that an operator may touch the adhesive surface of the splice tape. Therefore, there is little possibility that the operator may touch the adhesive surface of the splice tape. Accordingly, there is little possibility that the adhesive strength of the splice tape may be weakened. In addition, the splicing accuracy is unlikely to depend on the skill proficiency of the operator.
   In addition, according to the splicing device of the present invention, the splice tape among the first tape, the second tape and the splice tape is moved when the open position is switched over to the close position. That is, the first connecting end portion of the first tape and the second connecting end portion of the second tape do not move. Therefore, during the splicing work, the first connecting end portion and the second connecting end portion are unlikely to cause positional deviation from each other. That is, the splicing accuracy is unlikely to be degraded.
   (1-1) Preferably, in the configuration of the above-described (1), in the open position, a clamping angle between the stationary pressing member and the movable pressing member may be configured to be approximately 180°. According to this configuration, in the open position, it is possible to set the splice tape without bending the splice tape.
   (1-2) Preferably, the configuration of the above-described (1) may be configured to include an operation unit that is manually operated and supplies driving force to the movable pressing member when the open position is switched over to the close position.

   According to this configuration, an operator can carry out the splicing work by manually operating the operation unit. Therefore, even when there is no electricity supply, it is possible to accurately carry out the splicing work.
(2) According to the invention, in the configuration of the above-described (1), the splicing device further includes an elastic member that returns the movable pressing member to be automatically switched over from the close position to the open position, and a regulating unit that regulates the return motion of the movable pressing member using the elastic member, when the open position is switched over to the close position, if an actual movement amount of the movable pressing member does not reach a predetermined movement amount which enables the first connecting end portion and the second connecting end portion to be connected to each other.
   According to this configuration, if the actual movement amount of the movable pressing member does not reach the predetermined movement amount which enables the first connecting end portion and the second connecting end portion to be connected to each other, the movable pressing member is not returned. In other words, if the first connecting end portion and the second connecting end portion are not completely connected to each other, the movable pressing member is not returned. Therefore, it is possible to reliably carry out the splicing work.
   In particular, when this configuration is combined with the configuration of the above-described (1-2), the operator can easily recognize whether the manual movement amount of the movable pressing member is sufficient or insufficient. In addition, it is possible to prevent the splicing accuracy from being degraded due to weakened adhesive strength (when the movement amount of the movable pressing member is insufficient).
(3) Preferably, in the configuration of the above-described (1) or (2), the tape connecting unit may include a positioning unit which positions the first connecting end portion and the second connecting end portion with respect to the splice tape, in the close position, when the first connecting end portion and the second connecting end portion are connected to each other by the splice tape.
   When carrying out the splicing work, it is necessary to accurately position the first connecting end portion and the second connecting end portion with respect to the splice tape. However, the positioning work for the three members (splice tape, first tape and second tape) is cumbersome. In this regard, according to this configuration, it is possible to accurately and easily position the splice tape, the first connecting end portion and the second connecting end portion by using the positioning unit.
(4) Preferably, in the configuration of the above-described (3), the splice tape may have a first hole row configured to have a plurality of first positioning holes arrayed in a longitudinal direction of the splice tape, and a second hole row configured to have a plurality of second positioning holes juxtaposed in a short direction of the first hole row and arrayed in the longitudinal direction of the splice tape. The first tape may have a plurality of first feeding holes arrayed in the longitudinal direction of the first tape. The second tape may have a plurality of second feeding holes arrayed in the longitudinal direction of the second tape. The positioning unit may have a stationary positioning pin which is arranged in the stationary pressing member and is inserted into the first positioning hole, the first feeding hole and the second feeding hole from a rear side in the open position, and a movable positioning pin which is arranged in the movable pressing member, which is inserted into the second positioning hole from the rear side in the open position, and which is inserted into the first feeding hole and the second feeding hole from a front side when the open position is switched over to the close position.

In the open position, the stationary positioning pin of the positioning unit is inserted into the first positioning hole, the first feeding hole and the second feeding hole from the rear side. In this manner, the splice tape, the first connecting end portion and the second connecting end portion are fixed to the positioning unit. In addition, the movable positioning pin of the positioning unit is inserted into the second positioning hole from the rear side. In this manner, the slice tape is fixed to the positioning unit.

When the open position is switched over to the close position, the movable positioning pin is inserted into the first feeding hole and the second feeding hole from the front side, in addition to the second positioning hole into which the movable positioning pin has been already inserted. Therefore, the splice tape, the first connecting end portion and the second connecting end portion are positioned from the front and rear direction with respect to the positioning unit. In this state, the first connecting end portion and the second connecting end portion are connected to each other by the splice tape. According to this configuration, it is possible to accurately and easily position the splice tape, the first connecting end portion and the second connecting end portion by using the positioning unit.

### Advantageous Effects of Invention

According to the present invention, it is possible to provide a splicing device where splicing accuracy is unlikely to be degraded.

### Brief Description of Drawings

Fig. 1 is a perspective view of a splicing device which is an embodiment of a splicing device of the present invention.
Fig. 2 is an exploded perspective view of the splicing device.
Fig. 3 is a transparent right side view of the splicing device.
Fig. 4 is an exploded and transparent right side view of the splicing device.
Fig. 5 is an exploded view of a lower section in Fig. 4.
Fig. 6 is an exploded view of a middle section in Fig. 4.
Fig. 7 is an exploded view of an upper section in Fig. 4.
Fig. 8 is a perspective view illustrating a stationary pressing member and a movable pressing member of the splicing device in an open position.
Fig. 9 is a transparent side view while the open position is switched over to a close position in the splicing device.
Fig. 10 is a transparent right side view in the close position of the splicing device.
Fig. 11(a) is a schematic view of a first stage in splicing work for a tape. Fig. 11(b) is a schematic view of a second stage in the splicing work for the tape. Fig. 11(c) is a schematic view of a third stage in the splicing work for the tape.

### Reference Signs List

1: splicing device, 2: tape connecting unit, 3: operation unit, 5: regulating unit, 6: base, 7: link section, 9: splice tape. 20: stationary pressing member, 21: movable pressing member, 22: positioning unit, 23: stationary block, 24: guide shaft, 25: spring, 26: locking pin, 27: support portion, 30: pressing portion, 31: arm, 32: elastic member, 50: regulating member, 51: pawl member, 52: bracket, 53: spring, 61: stopper, 62: bracket, 70: first link member, 71: second link member, 72: third link member, 80: first tape, 81: second tape, 90: protective film, 91: front surface adhesive tape, 92: rear surface adhesive tape, 93: first hole row, 94: second hole row. 200: shaft accommodating recess, 201: shaft locking hole, 210: drive connecting portion, 211: guided portion, 212: tape support portion, 220: stationary positioning pin, 221: movable positioning pin, 222: stationary positioning hole, 223: movable positioning hole, 230: shaft insertion hole, 231: bush, 240: pressurized surface, 270: guide portion, 271: pivot shaft, 272: pivot shaft, 310: guide hole, 311: pivot shaft, 500: regulating teeth, 510: engagement portion, 511: non-engagement portion, 620: pivot shaft, 700: guided projection, 701: connecting shaft, 720: connecting shaft, 800: carrier tape, 801: cover tape, 802: first feeding hole, 803: component accommodating portion, 804: first connecting end portion, 810: carrier tape, 811: cover tape, 812: second feeding hole, 813: component accommodating portion, 814: second connecting end portion, 930: first positioning hole, 940: second positioning hole.

### Description of Embodiments

Hereinafter, an embodiment of a splicing device of the present invention will be described.

### <Configuration of Splicing Device>

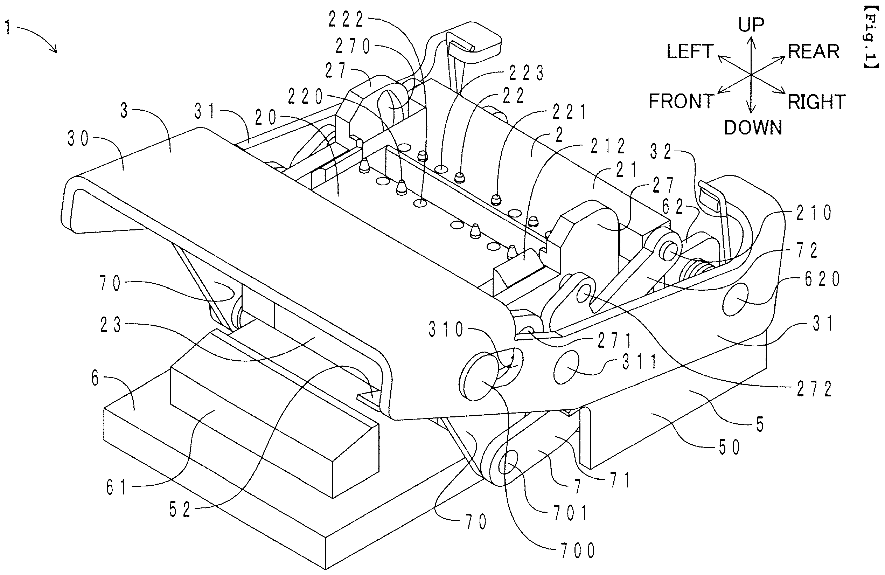

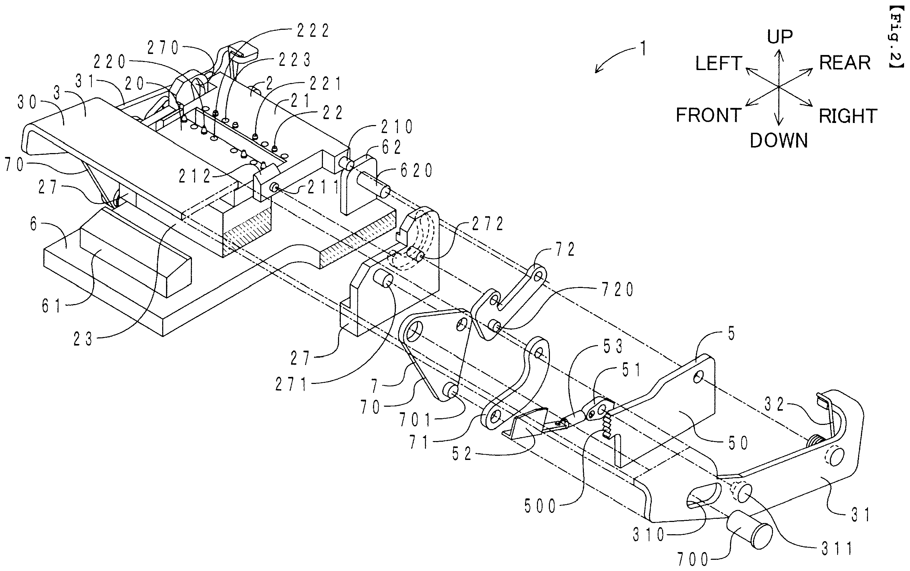

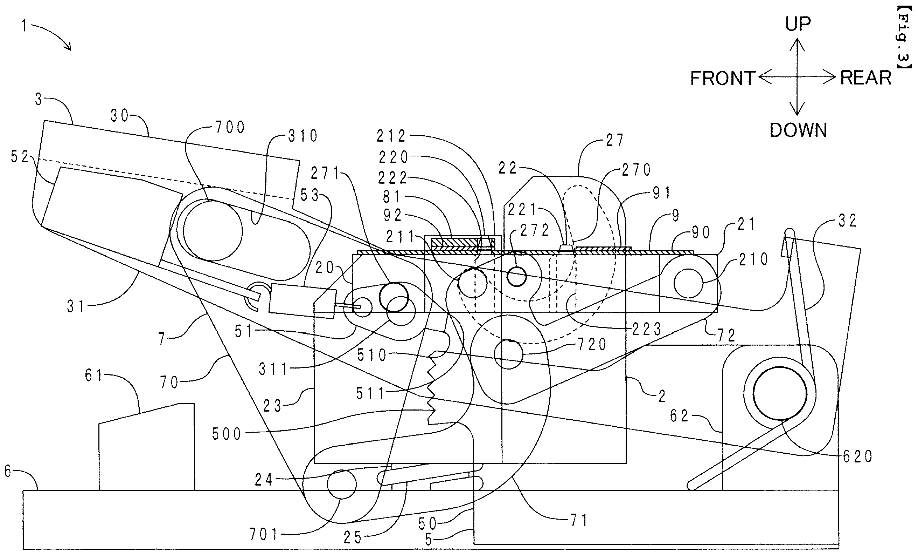

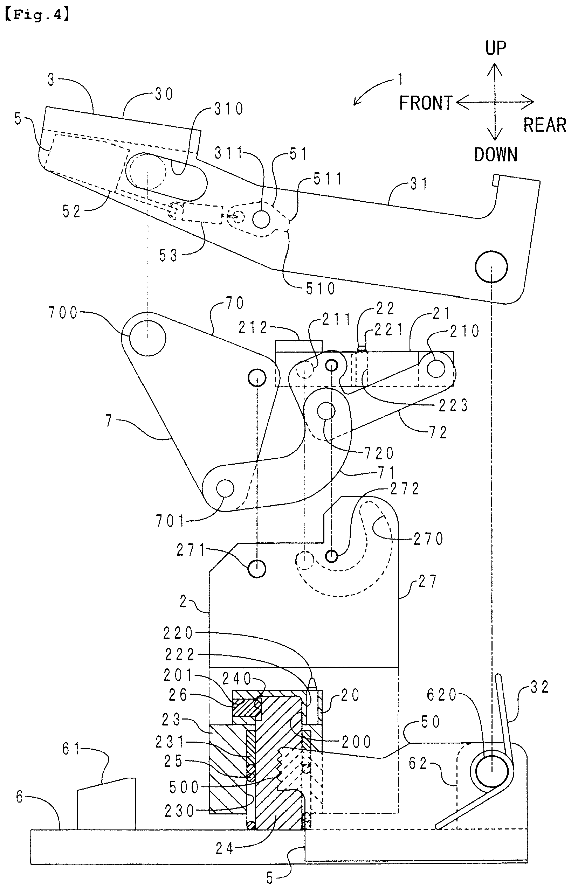

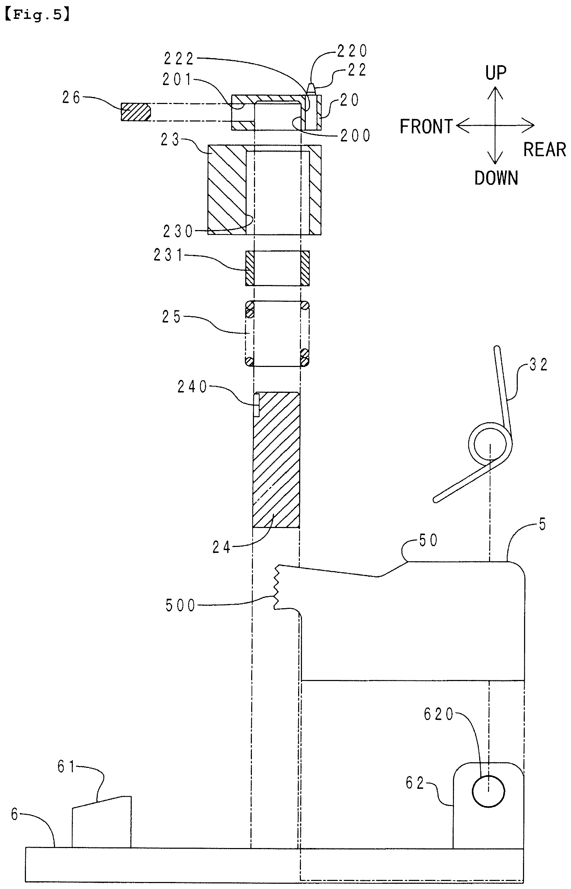

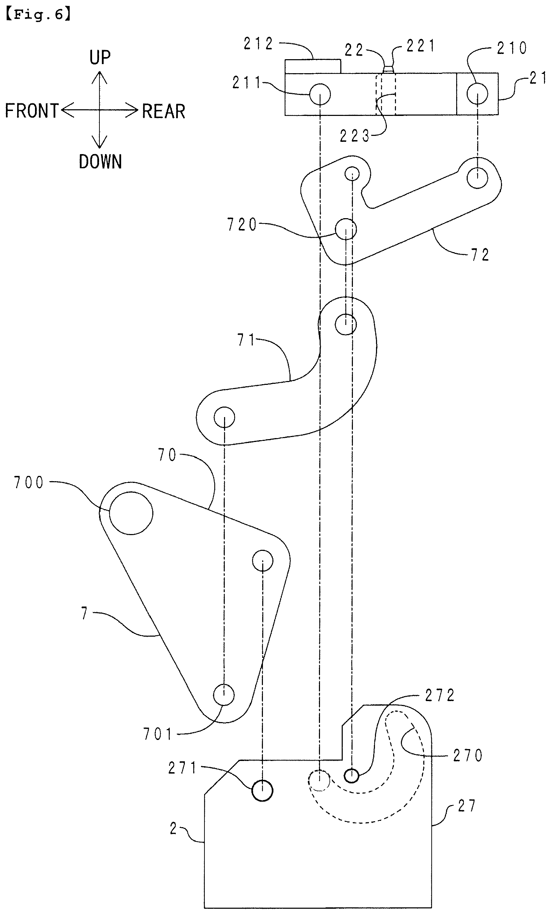

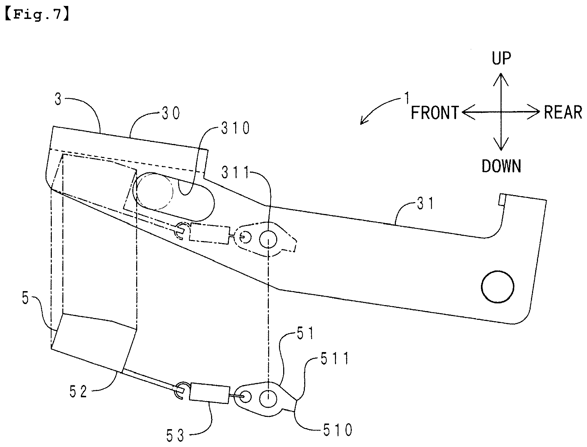

First, a configuration of the splicing device of the present embodiment will be described. Fig. 1 illustrates a perspective view of the splicing device of the present embodiment. Fig. 2 illustrates an exploded perspective view of the splicing device. Fig. 3 illustrates a transparent right side view of the splicing device. Fig. 4 illustrates an exploded and transparent right side view of the splicing device. Fig. 5 illustrates an exploded view of a lower section in Fig. 4. Fig. 6 illustrates an exploded view of a middle section in Fig. 4. Fig. 7 illustrates an exploded view of an upper section in Fig. 4. As illustrated in Figs. 1 to 7, a splicing device 1 includes a tape connecting unit 2, an operation unit 3, an elastic member 32, a regulating unit 5, a base 6 and a link section 7.

### [Base 6]

The base 6 includes a stopper 61 and a pair of brackets 62. The base 6 has a flat plate shape. The stopper 61 has a rectangular parallelepiped block shape. The stopper 61 is arranged on an upper surface of a front side portion of the base 6. The stopper 61 sets a bottom dead center of the operation unit 3 (to be described later). The pair of brackets 62 are arranged on the upper surface of a rear end portion of the base 6. A pivot shaft 620 projects respectively from a left surface (outer surface) of the left side bracket 62 and a right surface (outer surface) of the right side bracket 62.

### [Operation Unit 3 and Elastic member 32]

The operation unit 3 includes a pressing portion 30 and a pair of arms 31. The pair of arms 31 respectively have a thin plate shape extending in a front and rear direction. The pair of arms 31 are arranged to be separated from each other in a right and left direction. The pressing portion 30 has a flat plate shape. The pressing portion 30 is laid between front ends of the pair of arms 31. Pressing force is input to the pressing portion 30 by an operator. A pair of pivot shafts 620 are inserted into a rear end of the pair of arms 31. Therefore, the operation unit 3 can be pivoted around the pivot shaft 620. The pair of arms 31 respectively include a guide hole 310. A pair of guide holes 310 respectively have an elongated hole shape in the front and rear direction. A pivot shaft 311 projects from the left surface of the right side arm 31.

The elastic member 32 is a so-called return spring. The elastic member 32 is mounted around the pivot shaft 620. An end of the elastic member 32 is elastically disposed to the upper surface of the base 6. The other end of the elastic member 32 is elastically disposed to a rear end of the arm 31. The elastic member 32 biases the operation unit 3 in a direction away from the base 6.

### [Regulating Unit 5]

The regulating unit 5 includes a regulating member 50, a pawl member 51, a bracket 52 and a spring 53. The regulating member 50 has vertical wall shape. The regulating member 50 is fixed to a right surface (illustrated by hatching in Fig. 2) of the base 6. The regulating member 50 is arranged between the base 6 and the right side arm 31. A plurality of regulating teeth 500 is formed in a front edge of the regulating member 50.

The bracket 52 is arranged on a left surface of the right side arm 31. The pawl member 51 is inserted into the pivot shaft 311. The pawl member 51 can be pivoted around the pivot shaft 311. A non-engagement portion 511 having an obtuse angel is arranged in a rear upper corner of the pawl member 51. An engagement portion 510 having a right angle is arranged in a rear lower corner of the pawl member 51. The spring 53 is interposed between the bracket 52 and a front end of the pawl member 51. The spring 53 biases the pawl member 51 forwardly.

As will be described later, when a movable pressing member 21 is switched over from an open position to a close position, the pawl member 51 can move to the regulating teeth 500 only from above to below. On the other hand, when the movable pressing member 21 is switched over from the close position to the open position after completely reaching the close position, the pawl member 51 can move to the regulating teeth 500 from below to above.

### [Tape Connecting Unit 2]

The tape connecting unit 2 includes a stationary pressing member 20, the movable pressing member 21, a positioning unit 22, a stationary block 23, a pair of guide shafts 24, a pair of springs 25, a pair of locking pins 26 and a pair of support portions 27.

The pair of guide shaft 24 respectively have a round bar shape extending in an up and down direction. The guide shafts 24 project from the upper surface of the base 6. The pair of guide shafts 24 are arrayed in the right and left direction. Pressurized surfaces 240 having a planar shape are respectively arranged on an upper end front surface of the pair of guide shafts 24.

The stationary block 23 has a rectangular parallelepiped shape. The stationary block 23 includes a pair of shaft insertion holes 230 and a pair of bushes 231. The pair of shaft insertion holes 230 penetrate the stationary block 23 in the up and down direction. The pair of shaft insertion holes 230 are arrayed in the right and left direction. The guide shafts 24 are respectively inserted into the pair of shaft insertion holes 230. The pair of bushes 231 are respectively fitted to an upper portion of the shaft insertion hole 230.

The pair of springs 25 are respectively inserted into the shaft insertion holes 230. Lower ends of the pair of springs 25 are respectively elastically disposed to the upper surface of the base 6. Upper ends of the pair of springs 25 are respectively elastically disposed to the lower end of the bushes 231. The pair of springs 25 bias the entire tape connecting unit 2 (excluding the pair of guide shafts 24) upward.

The stationary pressing member 20 has a rectangular parallelepiped plate shape. The stationary pressing member 20 is arranged above the stationary block 23. The stationary pressing member 20 includes a pair of shaft accommodating recesses 200 and a pair of shaft locking holes 201. The pair of shaft accommodating recesses 200 are disposed to be recessed on a lower surface of the stationary pressing member 20. The pair of shaft accommodating recesses 200 are arrayed in the right and left direction. Upper ends of the pair of guide shafts 24 are accommodated in the pair of shaft accommodating recesses 200. The pair of shaft locking holes 201 are disposed to be bored in a front surface of the stationary pressing member 20. Rear ends of the pair of shaft locking holes 201 respectively communicate with the shaft accommodating recesses 200.

The pair of locking pins 26 are respectively screwed to the pair of shaft locking holes 201. Rear ends of the pair of locking pins 26 are respectively in pressurizing contact with the pressurized surfaces 240 of the guide shafts 24. The locking pin 26 prevents the stationary pressing member 20 from slipping out from the guide shaft 24 due to a biasing force of the spring 25.

As illustrated in Fig. 4, the stationary block 23 can move in the up and down direction between the upper surface of the base 6 and the lower surface of the stationary pressing member 20. That is, the stationary block 23, the pair of support portions 27 (to be described later) and the movable pressing member 21 (to be described later) can move in the up and down direction in a state of being biased by the spring 25. Therefore, when the movable pressing member 21 is switched over from the open position to the close position, the movable pressing member 21 can be pressed downward against the biasing force of the spring 25.

The movable pressing member 21 has a rectangular parallelepiped plate shape. As illustrated in Fig. 2, in the open position, the movable pressing member 21 is juxtaposed behind the stationary pressing member 20. The movable pressing member 21 can move from the open position to the close position where the movable pressing member 21 is reversed upward from the stationary pressing member 20 and is juxtaposed in the up and down direction. The movable pressing member 21 includes a pair of drive connecting portions 210, a pair of guided portions 211 and a pair of tape support portions 212. The pair of drive connecting portions 210 project from both right and left surfaces of the rear end of the movable pressing member 21. The pair of guided portions 211 projects from both right and left surfaces of the front end of the movable pressing member 21. The pair of tape support portions 212 projects from the upper surface of the front end of the movable pressing member 21.

As will be described later, the first tape and the second tape which are connection targets respectively have a C-shaped curling tendency which opens downward. In the open position, the first tape and the second tape ride over the pair of tape support portions 212 to be set in the stationary pressing member 20 by utilizing this curling tendency.

Members configuring the positioning unit 22 are arranged to be separated from the stationary pressing member 20 and the movable pressing member 21. The positioning unit 22 includes a plurality of stationary positioning pins 220, a plurality of movable positioning pins 221, a plurality of stationary positioning holes 222 and a plurality of movable positioning holes 223.

The plurality of stationary positioning pins 220 and the plurality of stationary positioning holes 222 are arranged in the rear side portion of the stationary pressing member 20. The plurality of stationary positioning pins 220 and the plurality of stationary positioning holes 222 are arrayed in one row in the right and left direction. The plurality of stationary positioning pins 220 and the plurality of stationary positioning holes 222 are alternately arranged.

The plurality of movable positioning pins 221 and the plurality of movable positioning holes 223 are arranged in the front side portion of the movable pressing member 21. The plurality of movable positioning pins 221 and the plurality of movable positioning holes 223 are arrayed in one row in the right and left direction. The plurality of movable positioning pins 221 and the plurality of movable positioning holes 223 are alternately arranged.

The movable positioning pin 221 and the stationary positioning hole 222 oppose each other in the front and rear direction. The stationary positioning pin 220 and the movable positioning hole 223 oppose each other in the front and rear direction. When the open position is switched over to the close position, the movable positioning pin 221 can enter the stationary positioning hole 222. In addition, the stationary positioning pin 220 can enter the movable positioning hole 223.

The pair of support portions 27 respectively have a vertical wall shape. As illustrated by hatching in Fig. 2, the pair of support portions 27 are respectively fixed to both right and left walls of the stationary block 23. The pair of support portions 27 respectively have a guide portion 270 and pivot shafts 271 and 272. The pair of guide portions 270 are respectively arranged on a right surface (inner surface) of the left side support portion 27 and a left surface (inner surface) of the right side support portion 27. The guide portion 270 has a C-groove shape when viewed from the left side or the right side. A pair of guided portions 211 are accommodated in the pair of guide portions 270. The guided portion 211 can move inside the guide portion 270 along a shape of the guide portion 270.

The pair of pivot shafts 271 are respectively arranged on the left surface (outer surface) of the left side support portion 27 and the right surface (outer surface) of the right side support portion 27. The pair of pivot shafts 271 are respectively arranged in front upper portions of the support portions 27. The pair of pivot shafts 272 are respectively arranged on the left surface (outer surface) of the left side support portion 27 and the right surface (outer surface) of the right side support portion 27. The pair of pivot shafts 272 are respectively arranged in a central upper portion of the support portion 27.

### [Link Section 7]

The link section 7 includes a pair of first link members 70, a pair of second link members 71 and a pair of third link members 72. The pair of first link members 70, the pair of second link members 71 and the pair of third link members 72 are arranged to be separated from one another on the outer side in the right and left direction of the pair of support portions 27.

A configuration and a movement of the first link member 70, the second link member 71 and the third link member 72 which are located on the left side are the same as a configuration and a movement of the first link member 70, the second link member 71 and the third link member 72 which are located on the right side. An arrangement of the first link member 70, the second link member 71 and the third link member 72 which are located on the left side is bilaterally symmetrical to an arrangement of the first link member 70, the second link member 71 and the third link member 72 which are located on the right side. Therefore, hereinafter, on behalf of these link members, the configuration and the movement of the first link member 70, the second link member 71 and the third link member 72 which are located on the right side will be described.

The first link member 70 has a triangular plate shape when viewed from the left side or the right side. The pivot shaft 271 is inserted into a rear end of the first link member 70 from the left side. Therefore, the first link member 70 can be pivoted around the pivot shaft 271. A guided projection 700 is fixed to a front end of the first link member 70 from the right side via the guide hole 310 of the arm 31. A connecting shaft 701 projects from a lower end right surface of the first link member 70.

The second link member 71 has a C-plate shape when viewed from the left side or the right side. The connecting shaft 701 is inserted into one C-shaped end (front end) of the second link member 71 from the left side. Therefore, the second link member 71 can be pivoted with respect to the first link member 70.

The third link member 72 has an L-plate shape when viewed from the left side or the right side. The pivot shaft 272 is inserted into one L-shaped end (front end) of the third link member 72 from the left side. Therefore, the third link member 72 can be pivoted around the pivot shaft 272. A connecting shaft 720 projects from a right surface of an L-shaped bent portion of the third link member 72. The connecting shaft 720 is inserted into the other C-shaped end (rear end) of the second link member 71. Therefore, the third link member 72 can be pivoted with respect to the second link member 71. The drive connecting portion 210 is inserted into the other L-shaped end (rear end) of the third link member 72 from the left side. Therefore, the third link member 72 can be pivoted with respect to the movable pressing member 21.

### <Configuration of Splice Tape, First Tape and Second Tape>

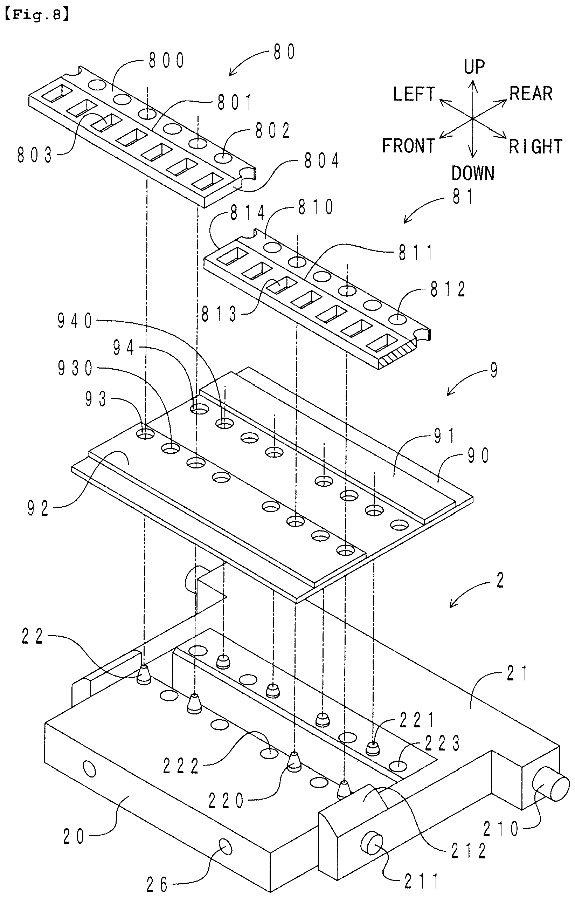

Next, a configuration of the splice tape, the first tape and the second tape will be described. Fig. 8 illustrates a perspective view in the open position of the stationary pressing member and the movable pressing member of the splicing device of the present embodiment.

As illustrated in Fig. 8, a splice tape 9 includes a protective film 90, a front surface adhesive tape 91, a rear surface adhesive tape 92, a first hole row 93 and a second hole row 94. The protective film 90 has a rectangular thin film shape. An upper surface of the protective film 90 is an adhesive surface.

The front surface adhesive tape 91 has a band shape extending in the right and left direction (longitudinal direction). The front surface adhesive tape 91 is arranged in a rear portion on an upper surface of the protective film 90 (upper surface portion of the movable pressing member 21). An upper surface of the front surface adhesive tape 91 is an adhesive surface.

The rear surface adhesive tape 92 has a band shape extending in the right and left direction. The rear surface adhesive tape 92 is arranged in a front portion on the upper surface of the protective film 90 (upper surface portion of the stationary pressing member 20). An upper surface of the rear surface adhesive tape 92 is an adhesive surface.

The first hole row 93 is configured to have a total of eight first positioning holes 930. The first hole row 93 extends in the right and left direction. The first hole row 93 is arranged in the front portion on the upper surface of the protective film 90. The first positioning hole 930 penetrates at the vicinity of a trailing edge of the rear surface adhesive tape 92 and the protective film 90 in the up and down direction (front and rear direction). The stationary positioning pins 220 are alternately inserted into eight first positioning holes 930 from below.

The second hole row 94 is configured to have a total of eight second positioning holes 940. The second hole row 94 extends in the right and left direction. The second hole row 94 is arranged in the rear portion on the upper surface of the protective film 90. The second positioning hole 940 penetrates the protective film 90 in the up and down direction. The movable positioning pins 221 are alternately inserted into eight second positioning holes 940 from below.

The first tape 80 includes a carrier tape 800, a pair of upper and lower cover tapes 801 (for convenience in description, transparently illustrated in Fig. 8), multiple first feeding holes 802 and multiple component accommodating portions 803. The multiple first feeding holes 802 are bored in the carrier tape 800. The multiple first feeding holes 802 are arranged at a predetermined pitch along the right and left direction of the carrier tape 800. The multiple component accommodating portions 803 are bored in the carrier tape 800. The multiple component accommodating portions 803 are arranged at a predetermined pitch along the right and left direction of the carrier tape 800. The pair of front and rear cover tapes 801 seal upper and lower openings of the component accommodating portion 803. The component accommodating portion 803 can accommodate electronic components (not illustrated). A first connecting end portion 804 is arranged in a right end of the first tape 80.

A configuration of the second tape 81 is the same as a configuration of the first tape 80. That is, the second tape 81 includes a carrier tape 810, a pair of upper and lower cover tapes 811, multiple second feeding holes 812 and multiple component accommodating portions 813. A second connecting end portion 814 is arranged in a left end of the second tape 81. The second connecting end portion 814 and the first connecting end portion 804 are in contact with each other in the right and left direction.

### <Splicing Work>

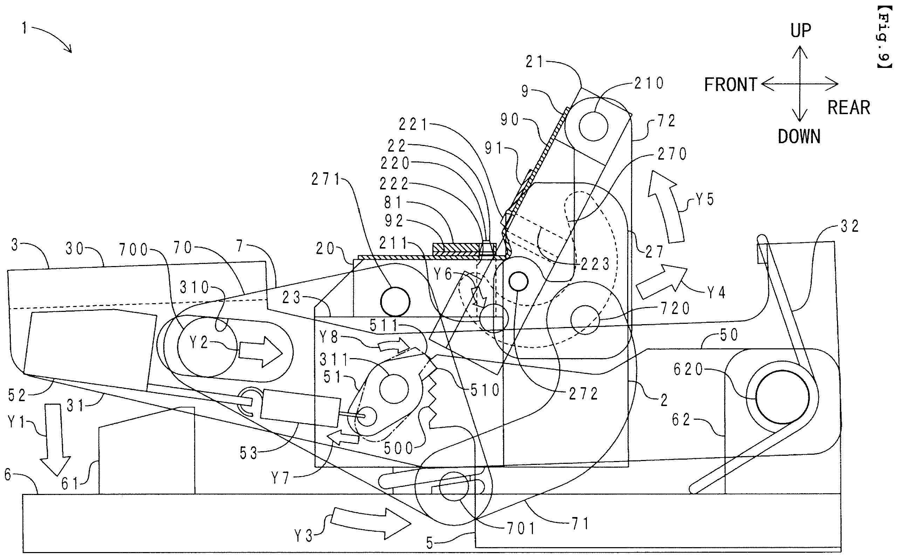

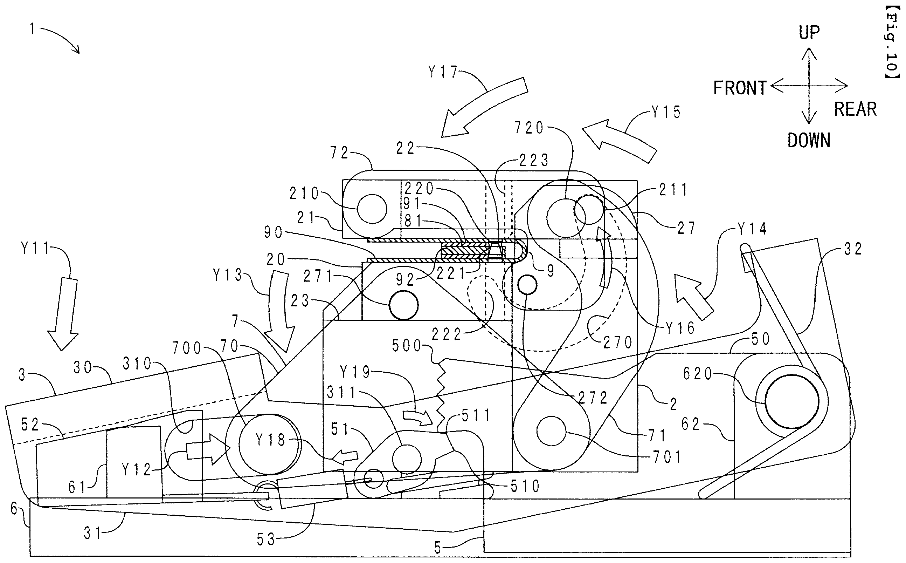

Next, the splicing work using the splicing device of the present embodiment will be described. Fig. 9 illustrates a transparent side view while the open position is switched over to the close position in the splicing device of the present embodiment. Fig. 10 illustrates a transparent right side view in the close position of the splicing device. Figs. 9 and 10 correspond to Fig. 3.

In the open position, as illustrated in Fig. 8, an operator first sets the splice tape 9, the first tape 80 and the second tape 81. Specifically, the operator first arranges the splice tape 9 on the upper surface of the stationary pressing member 20 and the upper surface of the movable pressing member 21. At this time, the stationary positioning pin 220 is inserted into the first positioning hole 930. In addition, the movable positioning pin 221 is inserted into the second positioning hole 940. In this manner, the splice tape 9 is positioned with respect to the stationary pressing member 20 and the movable pressing member 21.

Next, the operator arranges the first tape 80 in a left side portion of the splice tape 9. The first tape 80 has a curling tendency in a c-shape which opens downward. The first tape 80 is caused to ride over the left side tape support portion 212 to be set in the stationary pressing member 20 by utilizing this curling tendency. In addition, the stationary positioning pin 220 is inserted into the first feeding hole 802. Similarly, the operator arranges the second tape 81 in a right side portion of the splice tape 9. The second tape 81 has a curling tendency in a c-shape which opens downward. The second tape 81 is caused to ride over the right side tape support portion 212 to be set in the stationary pressing member 20 by utilizing this curling tendency. In addition, the stationary positioning pin 220 is inserted into the second feeding hole 812. In this manner, the first tape 80 and the second tape 81 are positioned with respect to the splice tape 9.

Next, as illustrated in Figs. 3, 9 and 10, the operator switches over the movable pressing member 21 from the open position to the close position. Specifically, the operator presses down the pressing portion 30 of the operation unit 3. As illustrated by an arrow Y1 in Fig. 9, the operation unit 3 is pivoted downward around the pivot shaft 620. At this time, the biasing force is accumulated in the elastic member 32. If the operation unit 3 is pivoted as illustrated by an arrow Y2 in Fig. 9, the guided projection 700 moves rearward inside the guide hole 310. If the guided projection 700 moves rearward as illustrated by an arrow Y3 in Fig. 9, the first link member 70 is pivoted around the pivot shaft 271 counterclockwise. If the first link member 70 is pivoted as illustrated by an arrow Y4 in Fig. 9, the second link member 71 is pressed out rearward. If the second link member 71 is pressed out as illustrated by an arrow Y5 in Fig. 9, the third link member 72 is pivoted around the pivot shaft 272 counterclockwise. If the third link member 72 is pivoted as illustrated by an arrow Y6 in Fig. 9, the guided portion 211 moves inside the guide portion 270 along the shape of the guide portion 270. Therefore, the guided portion 211, that is, the front end of the movable pressing member 21 is lowered. On the other hand, the drive connecting portion 210 of the movable pressing member 21 is connected to a tip of the third link member 72. Therefore, the drive connecting portion 210, that is, the rear end of the movable pressing member 21 is raised. That is, the movable pressing member 21 is pivoted counterclockwise.

In addition, in response to the pivotal movement of the operation unit 3, the pawl member 51 rides over the regulating teeth 500 from above to below. As illustrated by an arrow Y7 in Fig. 9, the pawl member 51 is pulled from the front by the spring 53. Therefore, as illustrated by an arrow Y8 in Fig. 9, the pawl member 51 is biased in a clockwise direction. Accordingly, even if the operator releases the operator's hand from the pressing portion 30 while the open position is switched over to the close position, the engagement portion 510 meshes with the regulating teeth 500. Thus, there is no possibility that the pawl member 51 may ride over the regulating teeth 500 from below to above. That is, there is no possibility that the operation unit 3 may be return to be in a state in Fig. 3.

If the operator further presses down the pressing portion 30, as illustrated by an arrow Y11 in Fig. 10, the operation unit 3 is pivoted downward around the pivot shaft 620 until the pressing portion 30 comes into contact with the stopper 61. At this time, the biasing force is further accumulated in the elastic member 32. In addition, as illustrated by an arrow Y12 in Fig. 10, the guided projection 700 reaches the rear end of the guide hole 310. In addition, as illustrated by an arrow Y13 in Fig. 10, the first link member 70 is further pivoted around the pivot shaft 271 counterclockwise. In addition, as illustrated by an arrow Y14 in Fig. 10, the second link member 71 is pivoted counterclockwise. In addition, as illustrated by an arrow Y15 in Fig. 10, the third link member 72 is pivoted counterclockwise. In addition, as illustrated by an arrow Y16 in Fig. 10, the guided portion 211 reaches the upper end of the guide portion 270. In addition, as illustrated by an arrow Y17 in Fig. 10, the movable pressing member 21 is reversed and the splice tape 9 is folded. Then, the folded splice tape 9 clamps the first tape 80 and the second tape 81 from the front and rear direction.

Here, as illustrated in Fig. 4, the stationary block 23, the pair of support portions 27, and the movable pressing member 21 can move in the up and down direction in a state of being biased by the spring 25. Accordingly, as illustrated in Fig. 10, when the movable pressing member 21 is switched over from the open position to the close position, it is possible to press the movable pressing member 21 downward against the biasing force of the spring 25. In contrast, the stationary pressing member 20 is fixed to the guide shaft 24 by the locking pin 26. Therefore, the stationary pressing member 20 does not move. Accordingly, it is possible to firmly clamp the first tape 80 and the second tape 81 between the movable pressing member 21 and the stationary pressing member 20 from the front and rear direction by using the splice tape 9.

The front surface adhesive tape 91 of the splice tape 9 adheres to the upper surface of the first tape 80 and the upper surface of the second tape 81. In addition, the rear surface adhesive tape 92 of the splice tape 9 adheres to the lower surface of the first tape 80 and the lower surface of the second tape 81. As illustrated in Fig. 8, the movable positioning pin 221 is inserted into the first feeding hole 802 of the first tape 80 and the second feeding hole 812 of the second tape 81 from the front side. Therefore, the first tape 80 and the second tape 81 can be connected to each other in a state of being positioned and clamped from the front and rear direction.

As illustrated by an arrow Y18 in Fig. 10, the pawl member 51 is pulled from the front by the spring 53. Therefore, if the pressing portion 30 comes into contact with the stopper 61, the pawl member 51 moves to the lower side of the regulating teeth 500 as illustrated by an arrow Y19 in Fig. 10.

If the operator releases the operator's hand from the pressing portion 30, the operation unit 3 is pivoted upward by the biasing force accumulated in the elastic member 32. That is, the movable pressing member 21 is switched over from the close position illustrated in Fig. 10 to the open position illustrated in Fig. 3. The splice tape 9 remains on the stationary pressing member 20 side by the adhesive strength.

At this time, the engagement portion 510 of the pawl member 51 does not engage with the regulating teeth 500. The non-engagement portion 511 of the pawl member 51 just traces the regulating teeth 500. In this manner, even if the operator releases the operator's hand from the operation unit 3 while the open position is switched over to the close position, the movable pressing member 21 is not return to reach the open position. On the other hand, if the operator releases the operator's hand from the operation unit 3 after the open position is completely switched over to the close position, the movable pressing member 21 is return to reach the open position.

Finally, the protective film 90 of the splice tape 9 is detached from the first tape 80 and the second tape 81 which are connected to each other. In this manner, the splicing work is carried out.

### <Operation and Effect>

Next, an operation and effect of the splicing device of the present embodiment will be described. According to the splicing device 1 of the present embodiment, it is possible to easily carry out the inherently cumbersome splicing work. In addition, a possibility that an operator may touch the adhesive surface of the splice tape 9 is present only when setting the splice tape 9, the first tape 80 and the second tape 81 in the open position. Therefore, there is little possibility that the operator may touch the adhesive surface of the splice tape 9. Accordingly, there is little possibility that the adhesive strength of the splice tape 9 may be weakened. In addition, the splicing accuracy is unlikely to depend on the proficiency in the operator's skill.

In addition, according to the splicing device 1 of the present embodiment, only the splice tape 9 among the first tape 80, the second tape 81 and the splice tape 9 moves when the open position is switched over to the close position. That is, the first connecting end portion 804 of the first tape 80 and the second connecting end portion 814 of the second tape 81 do not move. Therefore, when carrying out the splicing work, the first connecting end portion 804 and the second connecting end portion 814 are unlikely to cause positional deviation from each other. That is, the splicing accuracy is unlikely to be degraded.

In addition, according to the splicing device 1 of the present embodiment, the operator can carry out the splicing work by manually operating the operation unit 3. Therefore, even when there is no electricity supply, it is possible to accurately carry out the splicing work.

In addition, according to the splicing device 1 of the present embodiment, even if the operator releases the operator's hand from the pressing portion 30 while the open position is switched over to the close position, there is no possibility that the operation unit 3 may be returned to be in the state of Fig. 3. On the other hand, if the operator releases the operator's hand from the pressing portion 30 after completely reaching the close position, the operation unit 3 is pivoted upward by the biasing force accumulated in the elastic member 32. That is, the operation unit 3 is returned to be in the state of Fig. 3.

In this manner, according to the splicing device 1 of the present embodiment, if the first connecting end portion 804 and the second connecting end portion 814 are not completely connected to each other, the movable pressing member 21 is not switched over from the close position to the open position. Therefore, it is possible to reliably carry out the splicing work.

In addition, according to the splicing device 1 of the present embodiment, when the operator releases the operator's hand from the operation unit 3, if the operation unit 3 is automatically returned, the splicing work is eventually completed. On the other hand, when the operator releases the operator's hand from the operation unit 3, if the operation unit 3 is not automatically returned, the splicing work is not eventually completed. In this manner, it is possible for the operator to easily recognize whether or not the splicing work is completed. In addition, it is possible to prevent the splicing accuracy from being degraded due to weakened adhesive strength (when the movement amount of the movable pressing member 21 is insufficient).

In addition, according to the splicing device 1 of the present embodiment, in the open position, the stationary positioning pin 220 of the positioning unit 22 is inserted into the first positioning hole 930, the first feeding hole 802 and the second feeding hole 812 from below. In this manner, the splice tape 9, the first connecting end portion 804 and the second connecting end portion 814 are fixed to the positioning unit 22. In addition, the movable positioning pin 221 of the positioning unit 22 is inserted into the second positioning hole 940 from below. In this manner, the splice tape 9 is fixed to the positioning unit 22. When the open position is switched over to the close position, the movable positioning pin 221 is inserted into the first feeding hole 802 and the second feeding hole 812 from above, in addition to the second positioning hole 940 into which the movable positioning pin 221 has been already inserted. Therefore, the splice tape 9, the first connecting end portion 804 and the second connecting end portion 814 are positioned from the front and rear direction with respect to the positioning unit 22. In this state, the first connecting end portion 804 and the second connecting end portion 814 are connected to each other by the splice tape 9.

In this manner, according to the splicing device 1 of the present embodiment, it is possible to accurately and easily position the splice tape 9, the first connecting end portion 804 and the second connecting end portion 814 by using the positioning unit 22.

In addition, according to the splicing device 1 of the present embodiment, a trajectory of the drive connecting portion 210 (rear end) of the movable pressing member 21 is determined by the link section 7. On the other hand, a trajectory of the guided portion 211 (front end) of the movable pressing member 21 is determined by the guide portion 270. Therefore, as compared to a case where the movable pressing member 21 is pivoted within a constant pivotal movement radius, it is possible to reduce a pivotal movement trajectory of the movable pressing member 21. Accordingly, it is possible to miniaturize the splicing device 1.

In addition, according to the splicing device 1 of the present embodiment, substantially all of the components of the splicing device 1 are accommodated between the pressing portion 30 and the pivot shaft 620, when viewed from the left side or the right side. In other words, the tape connecting unit 2, the elastic member 32, the regulating unit 5 and the link section 7 are accommodated within the pivotal movement radius of the operation unit 3. Therefore, it is possible to miniaturize the splicing device 1.

In addition, according to the splicing device 1 of the present embodiment, as illustrated in Fig. 1, in the open position, the upper surface of the stationary pressing member 20 and the upper surface of the movable pressing member 21 are not overlapped with the pressing portion 30 in the up and down direction. Therefore, it is easy to set the splice tape 9, the first tape 80 and the second tape 81.

In addition, according to the splicing device 1 of the present embodiment, as illustrated in Figs. 4 and 10, it is possible to press the movable pressing member 21 downward against the biasing force of the spring 25. Therefore, it is possible to firmly clamp the first tape 80 and the second tape 81 from the front and rear direction by using the splice tape 9.

In addition, according to the splicing device 1 of the present embodiment, as illustrated in Fig. 3, in the open position, a clamping angle between the stationary pressing member 20 and the movable pressing member 21 (opening degree of the movable pressing member 21) is set to be approximately 180°. Therefore, it is possible to set the splice tape 9 without bending the splice tape 9.

In addition, according to the splicing device 1 of the present embodiment, as illustrated in Fig. 8, in the open position, it is possible to set the first tape 80 and the second tape 81 so as to ride over the pair of tape support portions 212 in the stationary pressing member 20 by utilizing the curling tendency of the first tape 80 and the second tape 81. Therefore, it is possible to easily set the first tape 80 and the second tape 81. In addition, the pair of tape support portions 212 are integrally arranged in the movable pressing member 21. Therefore, when the open position is switched over to the close position, the pair of tape support portions 212 are reversed by approximately 180° together with the movable pressing member 21. Accordingly, there is little possibility that the pair of tape support portions 212 may hinder the splicing work.

In addition, according to the splicing device 1 of the present embodiment, the first link member 70, the second link member 71 and the third link member 72 are arranged on both sides in the right and left direction of the tape connecting unit 2. Therefore, as compared to a case where the respective link members are arranged on only one side in the right and left direction of the tape connecting unit 2, it is possible to evenly apply the pressing force to the first tape 80, the second tape 81 and the splice tape 9, when the open position is switched over to the close position.

In addition, according to the splicing device 1 of the present embodiment, in the close position, the stationary positioning pin 220 can enter the movable positioning hole 223. In addition, the movable positioning pin 221 can enter the stationary positioning hole 222. Therefore, it is possible to decrease a gap in the up and down direction between the stationary pressing member 20 and the movable pressing member 21. Accordingly, it is possible to firmly connect the first tape 80 and the second tape 81. In addition, it is possible to prevent tips of the stationary positioning pin 220 and the movable positioning pin 221 from being crushed.

### <Others>

Hitherto, the embodiment of the splicing device of the present invention has been described. However, the embodiment is not particularly limited to the above-described embodiment. The embodiment can be modified and improved in various examples which those skilled in the art can perform.

In the above-described embodiment, as illustrated in Fig. 8, the first hole row 93 and the second hole row 94 are arranged near the center in the front and rear direction of the splice tape 9. However, the first hole row 93 and the second hole row 94 may be arranged near both front and rear edges of the splice tape 9. That is, the first hole row 93 and the second hole row 94 may be arranged so as to correspond to the arrangement of the first feeding hole 802 and the second feeding hole 812. In other words, the splice tape 9 may be replaced depending on types of the first tape 80 and the second tape 81. Similarly, depending on types of the first tape 80, the second tape 81 and the splice tape 9, the movable pressing member 21, the stationary pressing member 20, the stationary positioning pin 220 and the movable positioning pin 221 may be replaced.

In the above-described embodiment, the movable pressing member 21 is manually driven. However, the movable pressing member 21 may be driven by a motor, a solenoid, a ball screw, a fluid (oil, air or the like) cylinder or the like. That is, electric power may be used.

In the above-described embodiment, driving force is transmitted from the operation unit 3 to the movable pressing member 21 by the link section 7. However, the driving force may be transmitted from the operation unit 3 to the movable pressing member 21 by other power transmission mechanisms (for example, a cam mechanism or the like).

In the above-described embodiment, the opening degree of the movable pressing member 21 with respect to the stationary pressing member 20 is set to be approximately 180° in the open position. However, the opening degree is not particularly limited thereto. For example, the opening degree may be 90°, 180°, 270° or the like.

## Claims

1. A splicing device (1) comprising:
a tape connecting unit (2) that has a stationary pressing member (20) and a movable pressing member (21), which can switch between an open position opened to the stationary pressing member (20) and a closed position close to the stationary pressing member (20),
wherein in the open position, a splice tape (9) is arranged across the movable pressing member (21) and the stationary pressing member (20),
wherein in the open position, a first connecting end portion (804) of a first tape (80) and a second connecting end portion (814) of a second tape (81) are arranged on a surface of a portion of the stationary pressing member side within the splice tape (9), and
wherein by the open position being switched over to the closed position, the movable pressing member (21) is close to the stationary pressing member (20), the movable pressing member (21) is overlapped with the stationary pressing member (20) in a front and rear direction, the splice tape (9) is folded between the movable pressing member (21) and the stationary pressing member (20), the first connecting end portion (804) and the second connecting end portion (814) are clamped by the splice tape (9) from the front and rear direction, and the first connecting end portion (804) and the second connecting end portion (814) are connected to each other,
**characterized in that** the splicing device (1) further comprises:
an elastic member (32) that is configured to return the movable pressing member (21) to be automatically switched over from the close position to the open position; and
a regulating unit (5) that is configured to regulate a return motion of the movable pressing member (21) using the elastic member (32), when the open position is switched over to the closed position, if an actual movement amount of the movable pressing member (21) does not reach a predetermined movement amount which enables the first connecting end portion (804) and the second connecting end portion (814) to be connected to each other.

2. The splicing device (1) according to Claim 1,
wherein the tape connecting unit (2) includes a positioning unit (22) which is configured to position the first connecting end portion (804) and the second connecting end portion (814) with respect to the splice tape (9), in the closed position, when the first connecting end portion (804) and the second connecting end portion (814) are connected to each other by the splice tape (9).

3. The splicing device (1) according to Claims 1 or 2,
wherein the positioning unit (22) has a stationary positioning pin (220) which is arranged in the stationary pressing member (20) and is configured to be inserted into
a first positioning hole (930) of the splice tape (9) having a first hole row (93) having a plurality of first positioning holes (930) arrayed in a longitudinal direction of the splice tape (9), and a second hole row (94) having a plurality of second positioning holes (940) juxtaposed in a short direction of the first hole row (93) and arrayed in the longitudinal direction of the splice tape (9),
a first feeding hole (802) of the first tape (80) having a plurality of first feeding holes (802) arrayed in the longitudinal direction of the first tape (80), and
a second feeding hole (812) of the second tape (81) having a plurality of second feeding holes (812) arrayed in the longitudinal direction of the second tape (81) from a rear side in the open position,
and a movable positioning pin (221) which is arranged in the movable pressing member (21), which is configured to be inserted into the second positioning hole (940) from the rear side in the open position, and which is configured to be inserted into the first feeding hole (802) and the second feeding hole (812) from a front side when the open position is switched over to the close position.

## Patentansprüche

1. Spleißvorrichtung (1), umfassend:
eine Bandverbindungseinheit (2), die ein stationäres Presselement (20) und ein bewegliches Presselement (21) aufweist, das zwischen einer geöffneten Position, die zu dem stationären Presselement (20) geöffnet ist, und einer geschlossenen Position nahe dem stationären Presselement (20) wechseln kann,
wobei in der geöffneten Position ein Spleißband (9) über dem beweglichen Presselement (21) und dem stationären Presselement (20) angeordnet wird,
wobei in der geöffneten Position ein erster Verbindungsendabschnitt (804) eines ersten Bands (80) und ein zweiter Verbindungsendabschnitt (814) eines zweiten Bands (81) auf einer Oberfläche eines Abschnitts der stationären Presselement-Seite innerhalb des Spleißbandes (9) angeordnet werden, und
wobei sich durch das Wechseln von der geöffneten Position in die geschlossene Position das bewegliche Presselement (21) nahe dem stationären Presselement (20) befindet, das bewegliche Presselement (21) das stationäre Presselement (20) in einer Vorne-Hinten-Richtung überlappt, das Spleißband (9) zwischen dem beweglichen Presselement (21) und dem feststehenden Presselement (20) gefaltet wird, der erste Verbindungsendabschnitt (804) und der zweite Verbindungsendabschnitt (814) durch das Spleißband (9) aus der Vorne-Hinten-Richtung geklemmt werden und der erste Verbindungsendabschnitt (804) und der zweite Verbindungsendabschnitt (814) miteinander verbunden werden,
**dadurch gekennzeichnet, dass** die Spleißvorrichtung (1) ferner umfasst:
ein elastisches Element (32), das konfiguriert ist, das bewegliche Presselement (21) zurückzustellen, so dass es automatisch von der geschlossenen Position in die geöffnete Position wechselt; und
eine Reguliereinheit (5), die konfiguriert ist, eine Rückstellbewegung des beweglichen Presselements (21) unter Verwendung des elastischen Elements (32) zu regulieren, wenn von der geöffneten Position in die geschlossene Position gewechselt wird, falls ein Ist-Bewegungsbetrag des beweglichen Presselements (21) einen vorbestimmten Bewegungsbetrag nicht erreicht, der es ermöglicht, den ersten Verbindungsendabschnitt (804) und den zweiten Verbindungsendabschnitt (814) miteinander zu verbinden.

2. Spleißvorrichtung (1) gemäß Anspruch 1,
wobei die Bandverbindungseinheit (2) eine Positionierungseinheit (22) umfasst, die konfiguriert ist, den ersten Verbindungsendabschnitt (804) und den zweiten Verbindungsendabschnitt (814) bezüglich des Spleißbands (9) in der geschlossenen Position zu positionieren, wenn der erste Verbindungsendabschnitt (804) und der zweite Verbindungsendabschnitt (814) miteinander durch das Spleißband (9) verbunden werden.

3. Spleißvorrichtung gemäß Anspruch 1 oder 2,
wobei die Positionierungseinheit (22) einen stationären Positionierungsstift (220) aufweist, der in dem stationären Presselement (20) angeordnet ist und konfiguriert ist, in
ein erstes Positionierungsloch (930) des Spleißbands (9), das eine erste Lochreihe (93) aufweist, die eine Vielzahl von in einer Längsrichtung des Spleißbands (9) angeordneten ersten Positionierungslöchern (930) aufweist und eine zweite Lochreihe (94), die eine Vielzahl von zweiten Positionierungslöchern (940) aufweist, die in einer kurzen Richtung der ersten Lochreihe (93) nebeneinandergestellt sind und in der Längsrichtung des Spleißbands (9) angeordnet sind,
ein erstes Zuführloch (802) des ersten Bands (80), welches eine Vielzahl von ersten Zuführlöchern (802) aufweist, die in der Längsrichtung des ersten Bands (80) angeordnet sind, und
ein zweites Zuführloch (812) des zweiten Bands (81), welches eine Vielzahl von zweiten Zuführlöchern (812) aufweist, die in der Längsrichtung des zweiten Bands (81) angeordnet sind,
von einer Rückseite in der geöffneten Position eingesetzt zu werden,
und einen beweglichen Positionierungsstift (221), der in dem beweglichen Presselement (21) angeordnet ist, welcher konfiguriert ist, in der geöffneten Position in das zweite Positionierungsloch (940) von der Rückseite eingesetzt zu werden und welcher konfiguriert ist, in das erste Zuführloch (802) und das zweite Zuführloch (812) von der Vorderseite eingesetzt zu werden, wenn von der geöffneten Position in die geschlossene Position gewechselt wird.

## Revendications

1. Dispositif d'épissure (1) comprenant :
une unité de connexion de bande (2) qui a un élément de pression stationnaire (20) et un élément de pression mobile (21), pouvant commuter entre une position ouverte qui est ouverte vers l'élément de pression stationnaire (20) et une position fermée qui est fermée vers l'élément de pression stationnaire (20),
dans lequel, dans la position ouverte, une bande d'épissure (9) est disposée en travers de l'élément de pression mobile (21) et de l'élément de pression stationnaire (20),
dans lequel, dans la position ouverte, une première partie d'extrémité de connexion (804) d'une première bande (80) et une seconde partie d'extrémité de connexion (814) d'une seconde bande (81) sont agencées sur une surface d'une partie du côté élément de pression stationnaire à l'intérieur de la bande d'épissure (9), et
dans lequel, du fait que la position ouverte est commutée vers la position fermée, l'élément de pression mobile (21) est fermé vers l'élément de pression stationnaire (20), l'élément de pression mobile (21) est chevauché par l'élément de pression stationnaire (20) dans une direction avant et arrière, la bande d'épissure (9) est pliée entre l'élément de pression mobile (21) et l'élément de pression stationnaire (20), la première partie d'extrémité de connexion (804) et la seconde partie d'extrémité de connexion (814) sont serrées par la bande d'épissure (9) depuis la directions avant et arrière, et la première partie d'extrémité de connexion (804) et la seconde partie d'extrémité de connexion (814) sont connectées l'une à l'autre,
**caractérisé en ce que** le dispositif d'épissure (1) comprend en outre :
un élément élastique (32) qui est configuré pour ramener l'élément de pression mobile (21) pour qu'il soit commuté automatiquement de la position fermée vers la position ouverte ; et
une unité de régulation (5) qui est configurée pour réguler un mouvement de retour de l'élément de pression mobile (21) en utilisant l'élément élastique (32), lorsque la position ouverte est commutée vers la position fermée, si une quantité de mouvement réelle de l'élément de pression mobile (21) n'atteint pas une quantité de mouvement prédéterminée qui permet à la première partie d'extrémité de connexion (804) et à la seconde partie d'extrémité de connexion (814) d'être connectées l'une à l'autre.

2. Dispositif d'épissure (1) selon la revendication 1,
dans lequel l'unité de connexion de bande (2) comprend une unité de positionnement (22) qui est configurée pour positionner la première partie d'extrémité de connexion (804) et la seconde partie d'extrémité de connexion (814) par rapport à la bande d'épissure (9), dans la position fermée, lorsque la première partie d'extrémité de connexion (804) et la seconde partie d'extrémité de connexion (814) sont connectées l'une à l'autre par la bande d'épissure (9).

3. Dispositif d'épissure (1) selon les revendications 1 ou 2,
dans lequel l'unité de positionnement (22) a une broche de positionnement stationnaire (220) qui est agencée dans l'élément de pression stationnaire (20) et est configurée pour être insérée dans
un premier trou de positionnement (930) de la bande d'épissure (9) ayant une première rangée de trous (93) comportant une pluralité de premiers trous de positionnement (930) disposés dans une direction longitudinale de la bande d'épissure (9), et une seconde rangée de trous (94) ayant une pluralité de seconds trous de positionnement (940) juxtaposés dans une direction courte de la première rangée de trous (93) et disposés dans la direction longitudinale de la bande d'épissure (9),
un premier trou d'alimentation (802) de la première bande (80) comportant une pluralité de premiers trous d'alimentation (802) disposés dans la direction longitudinale de la première bande (80), et
un seconde trou d'alimentation (812) de la seconde bande (81) comportant une pluralité de seconds trous d'alimentation (812) disposés dans la direction longitudinale de la seconde bande (81) depuis un côté arrière dans la position ouverte,
et une broche de positionnement mobile (221) qui est agencée dans l'élément de pression mobile (21), qui est configurée pour être insérée dans le second trou de positionnement (940) depuis le côté arrière dans la position ouverte, et qui est configurée pour être insérée dans le premier trou d'alimentation (802) et le second trou d'alimentation (812) depuis un côté avant lorsque la position ouverte est commutée vers la position fermée.
